# EUROPÄISCHE PATENTANMELDUNG

(11) **EP 0 567 901 A1**
(43) Veröffentlichungstag der Anmeldung: **03.11.1993**
(21) Anmeldenummer: 93106410.9
(22) Anmeldetag: 20.04.1993
(51) Int. Cl.: H05K 9/00, H01R 4/64

(54) **Vorrichtung zum elektrischen Verbinden von zwei Bauteilen**

(30) Priorität: 29.04.1992 DE 9205771 U
(71) Anmelder: SIEMENS AKTIENGESELLSCHAFT, D-80333 München (DE)
(72) Erfinder: von Vietinghoff, Joachim, Dipl.-Ing-, W-7505 Ettlingen (DE)

(57) **Zusammenfassung**

Aus Gründen der elektromagnetischen Verträglichkeit (EMV) müssen in elektrischen Geräten zur Abschirmung oft einzelne Bauteile großflächig miteinander elektrisch verbunden werden. Zu diesem Zweck wird eine Vorrichtung zum elektrischen Verbinden von zwei Bauteilen vorgeschlagen, die eine möglichst gute elektrische Verbindung zwischen den Bauteilen auch beim häufigen Ein- bzw. Ausbau der Bauteile in bzw. aus einem elektrischen Gerät dadurch gewährleistet, daß Begrenzungsmittel zum Begrenzen der Bewegung des elastischen Elements (KF) der Vorrichtung in Richtung der Bauteile vorgesehen sind.

Die Erfindung wird angewandt in elektrischen Geräten.

## Beschreibung

Die Erfindung betrifft eine Vorrichtung zum elektrischen Verbinden von zwei Bauteilen mit einem elastischen, elektrisch leitenden Element. In einer bevorzugten Ausführungsform betrifft die Erfindung ein elektrisches Gerät.

Aus Gründen der elektromagnetischen Verträglichkeit (EMV) müssen in elektrischen Geräten zur Abschirmung oft einzelne Bauteile großflächig miteinander elektrisch verbunden werden. Zu diesem Zweck werden gewöhnlich Kontaktfedern eingesetzt, die mit einem Ende an einem Bauteil befestigt sind und mit dem anderen Ende mit dem anderen Bauteil kontaktieren. Werden die Bauteile in ein elektrisches Gerät häufig ein- und ausgebaut, besteht die Gefahr, daß sich die Kontaktfedern verbiegen. Eine ausreichende elektrische Verbindung zwischen den Bauteilen kann mit diesen Kontaktfedern dadurch nicht mehr hergestellt werden.

Der vorliegenden Erfindung liegt die Aufgabe zugrunde, eine Vorrichtung der eingangs genannten Art zu schaffen, die eine möglichst gute elektrische Verbindung zwischen den Bauteilen gewährleistet, insbesondere auch dann, wenn diese häufig in bzw. aus einem elektrischen Gerät ein- bzw. ausgebaut werden.

Diese Aufgabe wird dadurch gelöst, daß Begrenzungsmittel zum Begrenzen der Bewegung des elastischen Elements in Richtung der Bauteile vorgesehen sind.

Weiterbildungen der Erfindung sind in den Unteransprüchen beschrieben.

Anhand der Zeichnung, in der ein Ausführungsbeispiel der Erfindung dargestellt ist, werden die Erfindung, deren Ausgestaltungen und Vorteile näher erläutert.

Es zeigen
- Figur 1 und Figur 2: eine erste und eine zweite Ausführungsform der erfindungsgemäßen Vorrichtung und
- Figur 3: eine Draufsicht auf eine Anordnung mit Vorrichtungen nach Figur 1.

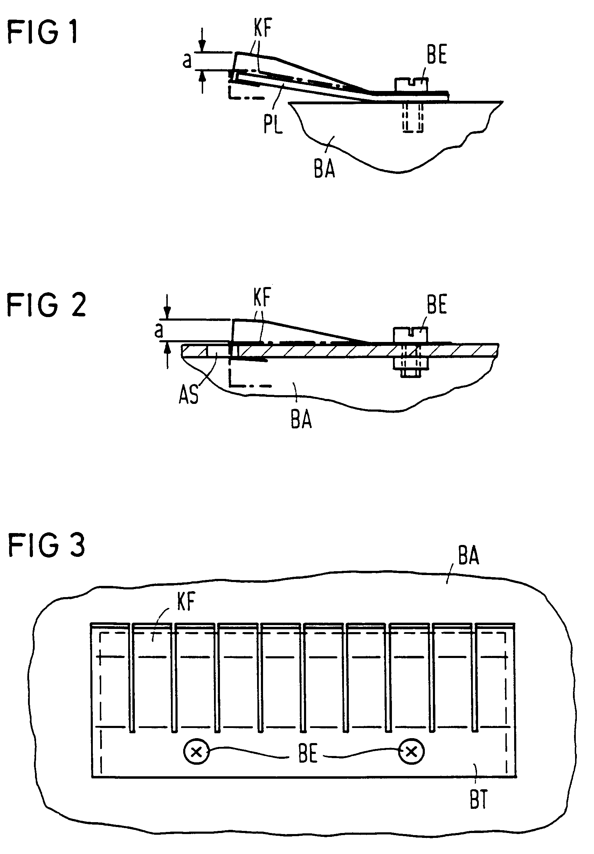

In Figur 1 ist mit BA ein erstes Bauteil einer Vorrichtung bezeichnet, das mit einem hier nicht dargestellten zweiten Bauteil über eine Kontaktfeder KF elektrisch verbunden ist. Die Verbindung wird dadurch bewirkt, daß das zweite Bauteil die ausgedehnte Feder nach unten in Richtung erstes Bauteil drückt (gestrichelt gezeichnet). Die Kontaktfeder KF ist mit ihrem festen Ende mit einem Befestigungselement BE an das erste Bauteil BA montiert und mit ihrem freien Ende U-förmig ausgebildet. Das erste Bauteil BA weist ein Begrenzungsmittel in Form eines mechanisch stabilen Plättchens PL auf, das ebenfalls mit dem Befestigungselement BE an dem ersten Bauteil BA montiert ist. Das Plättchen PL wird durch den U-förmigen Teil der Kontaktfeder KF umschlossen, wodurch die Kontaktfeder KF nur im Bereich eines zulässigen Federweges a bewegt werden kann, bei dem die Feder nicht überbelastet wird. Das Plättchen PL begrenzt die Bewegung der Kontaktfeder KF in Richtung des ersten Bauteils BA und der U-förmige Teil der Kontaktfeder KF in Richtung des zweiten Bauteils. Der maximal mögliche Federweg a ist etwas größer als die Toleranz des Abstandsmaßes für die Kontaktflächen der Bauteile. Die Begrenzung der Bewegung der Kontaktfeder KF verhindert vorteilhaft eine unzulässig große Verformung dieser Feder, und durch ihr U-förmiges Ende ist die Verletzungsgefahr beim Ein- und Ausbau der Bauteile beseitigt.

Figur 2 zeigt eine Ausführungsform der Erfindung. Die in den Figuren 1 und 2 dargestellten gleichen Teile sind mit gleichen Bezugszeichen versehen. Hier kann auf das Plättchen PL (Figur 1) verzichtet werden, indem das Bauteil BA im Bereich des freien Endes der Kontaktfeder KF einen Ausschnitt AS aufweist. Der U-förmige Teil ragt durch diesen schlitzförmigen Ausschnitt AS in das Bauteil BA und umschließt dabei eine Kante des Ausschnitts. Das Bauteil BA begrenzt die Bewegung der Kontaktfeder KF in Richtung dieses Bauteils, und der U-förmige Teil der Kontaktfeder KF begrenzt die Bewegung in Richtung des zweiten Bauteils, so daß wiederum nur der zulässige Federweg a zurückgelegt werden kann.

Um eine besonders großflächige Verbindung zwischen zwei Bauteilen herzustellen, sind in Figur 3 mehrere Kontaktfedern KF parallel angeordnet. Für eine derartige Anordnung ist es vorteilhaft, anstatt mehrerer Plättchen nur eine Platte vorzusehen, die als Begrenzungsmittel für alle Kontaktfedern KF dient. Die Kosten für die Herstellung einer solchen Platte sind geringer als die, die bei der Herstellung mehrerer kleiner Plättchen entstehen. Die Kontaktfedern KF sind miteinander elektrisch verbunden, vorzugsweise mit einem senkrecht zu den Federn stehenden Blechteil. In der Figur bildet ein Blechteil BT das feste Ende der Kontaktfedern KF, das mit Befestigungselementen BE an dem ersten Bauteil BA montiert ist.

In einer bevorzugten Ausführungsform der Erfindung weist ein elektrisches Gerät eine der in den Figuren 1 und 2 beschriebenen Vorrichtungen oder die in Figur 3 dargestellte Anordnung auf. Dadurch wird vorteilhaft vermieden, daß sich die Kontaktfedern beim häufigen Ein- und Ausbau der Bauteile in bzw. aus dem Gerät verbiegen, wodurch eine gute elektrische Verbindung nicht mehr gewährleistet ist.

## Patentansprüche

1. Vorrichtung zum elektrischen Verbinden von zwei Bauteilen mit einem elastischen, elektrisch leitenden Element (KF), **dadurch gekennzeichnet,** daß Begrenzungsmittel zum Begrenzen der Bewegung des elastischen Elements (KF) in Richtung der Bauteile vorgesehen sind.

2. Vorrichtung nach Anspruch 1, **dadurch gekennzeichnet,** daß das elastische Element (KF) mit einem festen und einem freien Ende versehen ist, wobei das feste Ende mit einem Bauteil (BA) verbunden ist und ein Begrenzungsmittel aufweist, das die Bewegung in Richtung dieses Bauteils (BA) begrenzt, und das freie Ende derart geformt ist, daß das elastische Element (KF) mit diesem Begrenzungsmittel zusammenwirkt, so daß die Bewegung des freien Endes in Richtung des anderen Bauteils begrenzt wird.

3. Vorrichtung nach Anspruch 2, **dadurch gekennzeichnet,** daß das elastische Element eine Kontaktfeder (KF) ist, deren freies Ende senkrecht zur Bewegungsrichtung U-förmig abgewinkelt ist.

4. Vorrichtung nach Anspruch 3, **dadurch gekennzeichnet,** daß das mit dem festen Ende verbundene Bauteil ein mechanisch stabiles Plättchen (PL) aufweist, das am Befestigungspunkt des festen Endes zwischen der Kontaktfeder (KF) und diesem Bauteil montiert ist, wobei die Kontaktfeder (KF) mit dem U-förmigen, freien Ende das Plättchen (PL) umschließt.

5. Vorrichtung nach Anspruch 3, **dadurch gekennzeichnet,** daß das mit dem festen Ende versehene Bauteil einen Ausschnitt (AS) aufweist, wobei eine Kante des Ausschnitts von dem U-förmigen, freien Ende der Kontaktfeder (KF) umschlossen wird.

6. Anordnung mit mindestens zwei parallel angeordneten Vorrichtungen nach einem der Ansprüche 1 bis 5, wobei die Vorrichtungen miteinander elektrisch verbunden sind.

7. Elektrisches Gerät mit einer Vorrichtung nach einem der Ansprüche 1 bis 5.

8. Elektrisches Gerät mit einer Anordnung nach Anspruch 6.
